Europäisches Patentamt

(19) European Patent Office

Office européen des brevets

(11) **EP 0 720 237 A1**

## (12) EUROPEAN PATENT APPLICATION

(43) Date of publication:
**03.07.1996 Bulletin 1996/27**

(51) Int. Cl.$^6$: **H01L 29/866**

(21) Application number: **94830597.4**

(22) Date of filing: **30.12.1994**

(84) Designated Contracting States:
**DE FR GB IT**

(71) Applicant: **SGS-THOMSON MICROELECTRONICS S.r.l.**
**I-20041 Agrate Brianza (Milano) (IT)**

(72) Inventors:
- **Villa, Flavio**
  **I-20100 Milano (IT)**
- **Ferrari, Paolo**
  **I-21013 Gallarate (VA) (IT)**

### (54) Zener diode for integrated circuits

(57)   Zener diode with high stability in time and low noise for integrated circuits and provided in an epitaxial pocket insulated from the rest of a type N epitaxial layer grown on a substrate of type P semiconductor material.

In said pocket are included a type N+ cathode region and a type P anode region enclosing it.

The cathode region has a peripheral part surrounding a central part extending in the anode region less deeply than the peripheral part.

FIG. 3

## Description

The present invention relates to a Zener diode for integrated circuits and specifically to those known to those skilled in the art as "buried Zener".

In integrated circuits Zener diodes are amply used as a voltage reference and for this use an indispensable characteristic is long term stability together with limited thermal drift and low noise level.

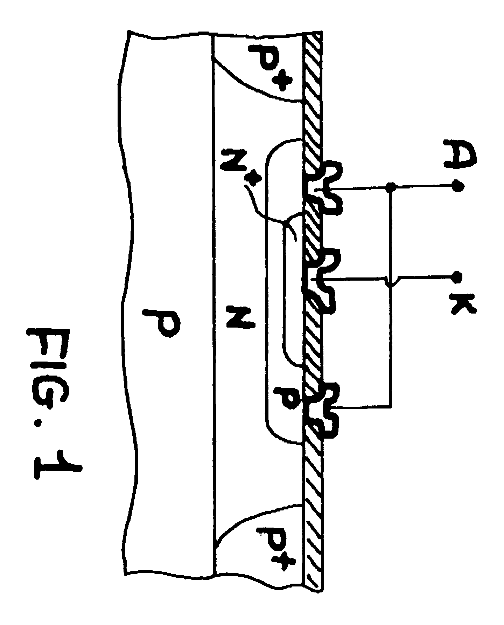

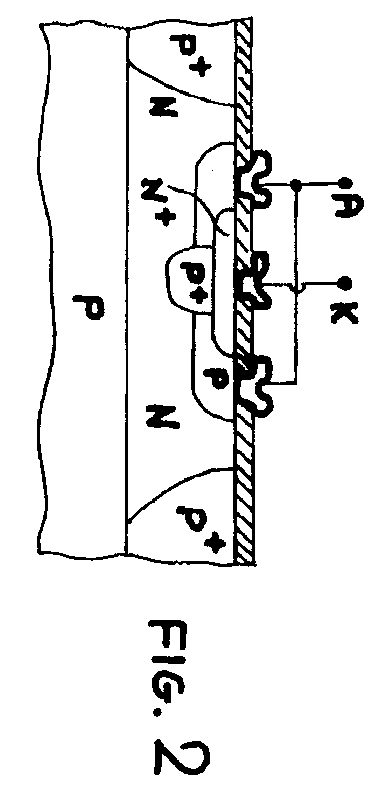

In accordance with the known techniques Zener diodes can be implemented in accordance with two main configurations as shown in FIGS. 1 and 2 of the annexed drawings. In said figures are indicated respectively the "surface Zener" configuration so-called because in it the breakdown of the bipolar junction in reverse polarisation takes place essentially near the surface of the semiconductor chip where the junction curvature is greater and the "buried Zener" configuration so-called because it is capable of confining the breakdown mechanism of the bipolar junction to below the device surface.

Zener surface diodes show in the long term poor stability due to ion contamination, typically sodium, present in the device oxides modifying the width of the depletion junction region and due to neutralisation of the dopant ions of the type P regions due to hydrogen ions (formation e.g. of B-H bonds) deriving from nitride layers used for device passivation.

They also exhibit not negligible thermal drift and high noise levels.

The above problems are discussed for example in the following articles.

(1) L. Terry, H. Pirastehfar, R. Rutter - "Passivation Induced Voltage Breakdown Shifting in Surface Zener Structure", 1990 ISTFA Proceedings pages 241-244.
(2) J. Dunkley et al - "Hot Electron Induced Hydrogen Compensation of Boron Doped Silicon Resulting from Emitter-Base Breakdown", "Technical Digest Int. Electron device Meeting" 1992 IEEE.

As appears from both the figures, the Zener diodes are provided in general by reverse biasing of the base-emitter junction of a vertical NPN transistor.

In the typical buried Zener diode structure as shown in FIG. 2 there is noted a deep P+ diffusion indicated in the technical literature as "P+ plug" which is in addition to the usual integration process steps and provided before the base P and emitter N+ diffusion which are anode and cathode regions respectively.

The N+ emitter region completely covers the P+ diffusion. The base-emitter breakdown mechanism which the Zener diode provides takes place in two steps.

First the breakdown takes place in the zone of greater dopant concentration, i.e. at the intersection between the N+ and P+ zones inside the structure.

After this first breakdown at a voltage BV1 there follows a second at a higher voltage BV2 which involves the N+P junction.

The current in the Zener is fixed in such a manner that the Zener voltage Vz is between BV1 and BV2, i.e.:

$$BV1 < Vz < BV2$$

As concerns thermal drift of Vz we can observe that it can be reduced or annulled by acting on the P+ zone doping. This occurs for doping concentrations of the P+ zone corresponding to breakdown voltages around 5V.

Indeed, for voltages less than 5V the breakdown phenomenon is due to electron tunnelling and the electrical field generated by the voltage applied, even though low, breaks the covalent bonds between the silicon atoms nearby to obtain electrons and conduction holes predominates.

This phenomenon is favoured by temperature increases and causes the resulting voltage coefficient to be negative with decrease of the voltage necessary to start the breakdown phenomenon with increasing temperature.

For voltages greater than 5V avalanche multiplication - or impact ionisation - predominates. In this phenomenon if the electrical field present is sufficiently high the electron and the hole thermally generated can reach, before undergoing collision with the crystalline grid, a kinetic energy level sufficient to break the silicon-silicon bonds and give rise to formation of other electron-hole pairs until it originates an avalanche phenomenon.

For voltages around 5V the two different phenomena cause jointly a compensation of the effects so that the thermal coefficient of Vz is virtually null.

As concerns noise due to the avalanche process, which shows a white spectrum from 100 Hz to 100 Mz, it can be progressively reduced by increasing the dopant concentration of the P+ zone. A good compromise between current loss or leakage of the junction and reduced noise is assured with Zener diode structures whose breakdown voltage is around 5V. For buried Zener diode structures there are obtained noise values of the avalanche type of $400nV/\sqrt{Hz}$ for a current Iz=10μA. With the same structures for higher breakdown voltages, e.g. around 6V and 10V, there are observed noise voltages Vn of $1.25\mu V/\sqrt{Hz}$ and $37 \mu V/\sqrt{Hz}$ respectively.

Structures of the type shown in FIG. 2 display not negligible noise levels of the so-called "burst" and "microplasma" types because of the crystallographic defects induced by the high dopant concentration of the P+ layer.

In integrated circuits there is sometimes a need to insert Zener diodes at critical points as concerns noise performance. In some applications , e.g. D/A converters, reference voltage fluctuations must be less than the level transactions of the last significant bit, otherwise the conversion would be distorted.

In such cases it is basically important to have available structures capable of ensuring reduced noise levels together with null thermal drift and high long-term stability.

The technical problem underlying the present invention is to provide a Zener diode for integrated circuit devices which, in comparison with known buried Zener diodes, would have a lower noise level.

The problem is solved by a Zener diode of the type indicated above and defined in the characterising part of the claims following this description.

The characteristics and advantages of the Zener diode in accordance with the present invention are set forth in the description of an embodiment thereof given below by way of non-limiting example with reference to the annexed drawings.

In the drawings:

- FIGS. 1 and 2 show cross sections of two different known types of Zener diode structures, and
- FIGS. 3 and 4 show respectively a cross section and a plan view of a Zener diode structure in accordance with the present invention.

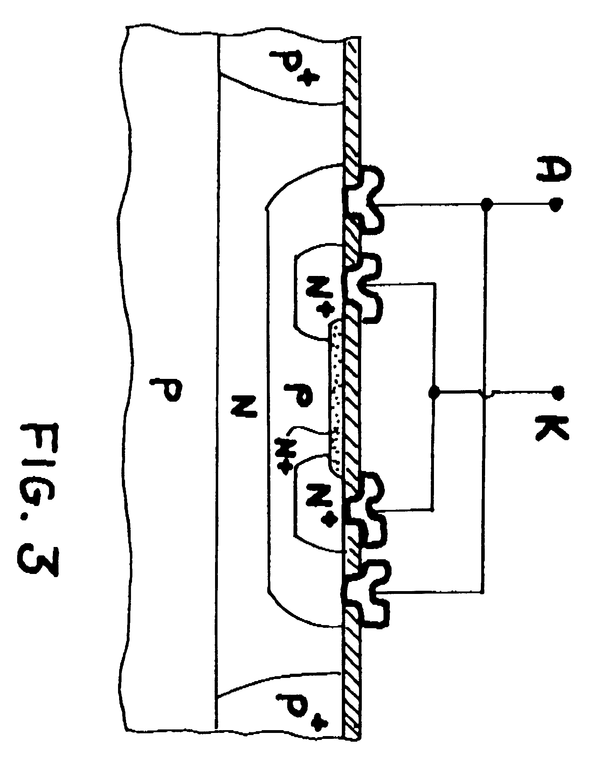

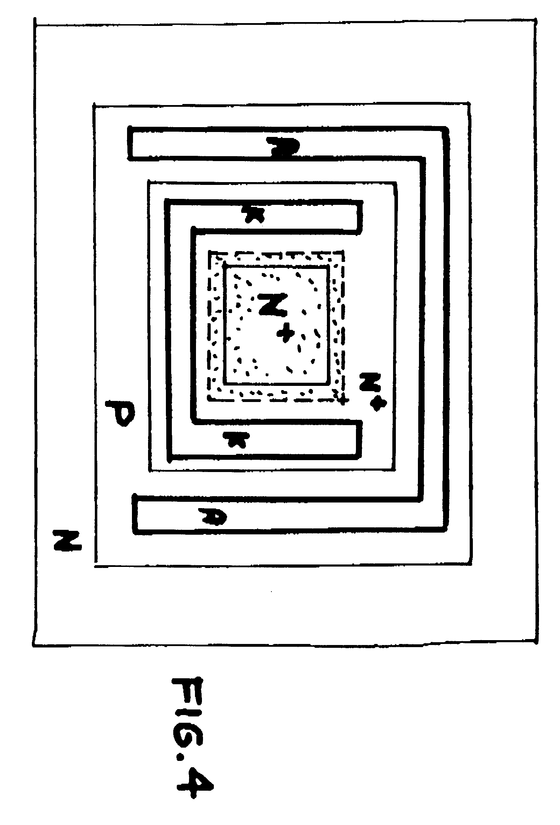

FIG. 3 of the drawings shows a cross section of the structure of a Zener diode in accordance with the present invention while FIG. 4 shows a possible topography of an implementation thereof with an integrated circuit. Even in this case it is a "buried" Zener diode but with better characteristics than the known ones.

Differently from those, a Zener diode in accordance with the present invention does not exhibit a deep P+ central diffusion while its essential characteristic is a shallower central zone in the N+ cathode region whose contacts are open in its deeper peripheral zone.

In a normal bipolar process the P anode region is provided by the same masking and diffusion operations used for constructing the base region of an NPN transistor while the N+ cathode region is provided in accordance with the present invention in two separate process steps.

In a first phase the deeper peripheral part shaped in a ring of the N+ cathode region is provided by the same masking and diffusion operations used to make the emitter region of an NPN transistor.

Subsequently by using an additional masking operation and an ion implantation of pentavalent atoms (As, P,...) there is provided in the internal zone of the ring a part of the N+ cathode region thinner, i.e. shallower, than the peripheral zone.

In practice, instead of increasing the dopant concentration in a central zone of the P+ layer as in the conventional "buried" Zener diodes, the depth of the N+ layer is reduced in the same zone.

The concentration of the P region at the metallurgical junction in said zone is automatically increased and the breakdown voltage correspondingly reduced.

Therefore even in a Zener diode in accordance with the present invention the first breakdown of the bipolar junction takes place as in the known "buried" type in a "buried" zone and not at the surface.

The new structure thus exhibits all the advantages indicated above for the "buried" Zener diodes but at the same time exhibits greatly reduced "microplasm" and "burst" noise levels thanks to the fact that the P anode region is on the whole much less doped.

In conclusion, besides the advantage of nearly null thermal drift and the excellent compromise achievable between the leakage current of the junction and "avalanche" noise reduction around the breakdown voltage of only 5V and besides the high long-term stability, the new Zener diode structure has better microplasm and burst noise reduction thanks to the lesser doping of the P anode region.

The total peak-to-peak noise is drastically reduced which is extremely advantageous as mentioned in certain applications.

It is also interesting to note that while the known buried Zener diodes are provided by integration processes calling generally for growth of an epitaxial layer of type N semiconductor material on a substrate of type P semiconductor material and insulation with P+ zones of epitaxial pockets N in which are provided diodes and transistors, a Zener diode in accordance with the present invention can be provided directly on a type P substrate which thus acts as an anode.

It is clear that modification, integration and replacement of elements can be made to the embodiment described above by way of nonlimiting example without thereby going beyond the protective scope of the following claims.

For example, the semiconductor substrate could be type N and thus the polarities of the different regions would be appropriately varied.

**Claims**

1. Bipolar junction device integrated monolithically and comprising a semiconductor substrate having a first type of conductivity and characterised in that in said substrate there is at least one region extending therein from one of its surfaces and having a second type of conductivity opposite the first and which has a peripheral part surrounding a central particular having at least one zone in which it extends in the substrate less deeply than the peripheral part.

2. Bipolar junction device in accordance with claim 1 and characterised in that the above first region is the cathode region of a Zener diode whose anode region is the substrate.

3. Bipolar junction device in accordance with claim 3 and characterised in that the central part of said first region is doped with pentavalent atom ions implanted therein by ion implantation.

4. Bipolar junction device integrated monolithically and comprising a semiconductor substrate having a conductivity of a first type on which there is at least one semiconductor layer having conductivity of a second type opposite the first and characterised in that in at least one zone of said layer there are at least a first and a second regions extending therein from its surface and having conductivity respectively of the second and first types and the second region enclosing the first which has a peripheral part surrounding a central part having at least one zone in which it extends in the second region less deeply than the peripheral part.

5. Bipolar junction device in accordance with claim 4 and characterised in that the above said at least one zone of said layer is insulated from the other zones of the layer by means of an insulation region having conductivity of the first type and extending from the surface of the layer to the substrate.

6. Bipolar junction device in accordance with either of claims 4 and 5 and characterised in that the above said first region is the cathode region of a Zener diode whose anode region is the above said second region.

7. Bipolar junction device in accordance with any one of claims 4, 5 or 6 and characterised in that the substrate and the second region are doped with type P ions and the layer and first region are doped with type N ions.

8. Bipolar junction device in accordance with claim 7 and characterised in that the layer is the epitaxial type grown on the substrate and that the central part of the first region is doped with pentavalent atom ions implanted therein by means of ion implantation.

9. Fabrication procedure for an integrated circuit device with at least one Zener type circuit element and comprising the following operations:

   - growth of at least one epitaxial semiconductor layer doped with impurities of a first type (N) on a semiconductor substrate doped with impurities of a second type (P),
   - insulation of at least a part of said epitaxial layer by means of an insulation zone doped with impurities of the second type (P+) extending from the surface of the epitaxial layer to the substrate, and
   - creation of a region extending on the surface of the layer and doped with impurities of the second type (P) in said at least one insulated epitaxial layer part by preparation on the surface of the layer and diffusion therein of impurities in a predetermined zone,
   and characterised in that it comprises operations for creation of a region doped with impurities of the first type (N+) extending from the surface of the epitaxial layer in the region doped with impurities of the second type by preparation on the surface of the layer and diffusion therein of impurities to a first depth to create a peripheral zone of said region doped with impurities of the first type (N+) and by ion implantation of impurities to create at least one zone of said region doped with impurities of the first type surrounded by said peripheral zone with predetermined implantation energy for implantation of the impurities to a second depth less than the first.

FIG. 1

FIG. 2

EP 0 720 237 A1

FIG. 3

EP 0 720 237 A1

FIG.4

N

P

N

P

N+

P

N+

**European Patent Office**

## EUROPEAN SEARCH REPORT

Application Number

EP 94 83 0597

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DE-A-29 28 758 (ROBERT BOSCH GMBH) * the whole document * | 1,2 | H01L29/866 |
| X | EP-A-0 159 129 (MOTOROLA INC.) * abstract; figure 2 * | 1 | |
| A | | 2 | |
| X | GB-A-2 130 792 (BURR-BROWN RESEARCH CORPORATION) | 4-7 | |
| A | * the whole document * | 8,9 | |
| A | EP-A-0 426 241 (SGS-THOMSON MICROELECTRONICS S.R.L.) * abstract; figure 7 * | 3,8,9 | |

TECHNICAL FIELDS
SEARCHED       (Int.Cl.6)

H01L

The present search report has been drawn up for all claims

| Place of search | Date of completion of the search | Examiner |
|---|---|---|
| THE HAGUE | 23 May 1995 | Baillet, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)